# DEMANDE DE BREVET EUROPEEN

(11) **EP 1 367 646 A1**
(43) Date de publication de la demande: **03.12.2003**
(21) Numéro de dépôt: 02405413.2
(22) Date de dépôt: 23.05.2002
(51) Int. Cl.: H01L 25/065

(54) **Module électronique**

(71) Demandeur: Valtronic S.A., 1343 Les Charbonnières (CH)
(72) Inventeur: Clot, Philippe, 1343 Les Charbonnières (CH); Zeberli, Jean-Francois, 1347 Le Sentier (CH)
(74) Mandataire: Gresset, Jean

(57) **Abrégé**

L'invention concerne un module électronique (10) qui comporte :
- un support d'interconnexion comprenant un substrat (12) souple, semi-rigide ou rigide doté d'une pluralité de zones de contact (14) déposées sur sa face supérieure (16),
- une première puce électronique (18), fixée sur le substrat (12) par sa face inactive et dotée, sur sa face active (20), d'une pluralité de plages de contact (22), et
- une deuxième puce électronique (26), dont la face active est dotée de protubérances conductrices (30), et montée sur la face active (20) de la première puce (18) de manière à mettre en contact lesdites protubérances (30) et lesdites plages (22).

## Description

La présente invention se rapporte aux techniques d'assemblage des circuits intégrés, aussi communément désignés puces électroniques. Elle concerne, plus particulièrement, un module électronique constitué d'un support d'interconnexion appelé également PCB (de l'anglais Printed Circuit Board) et d'au moins deux puces fixées sur celui-ci.

Les exigences toujours plus grandes de miniaturisation des modules électroniques imposent une évolution simultanée des techniques d'assemblage des différents composants sur leur support.

Le procédé d'assemblage traditionnel est le procédé, dit "Chip on Board", selon lequel les puces sont directement collées sur le substrat par leur face inactive. Les plages de contact de leur face active sont ensuite connectées aux plages de contact du PCB, plus communément appelées "pads", par de simples fils.

Un autre procédé, également très connu désormais, est la technique, dite "Flip Chip", selon laquelle les puces, retournées, sont fixées par l'intermédiaire de protubérances conductrices, plus souvent appelées "bumps", sur les plages de contact du support d'interconnexion. Une demande de brevet européenne a d'ailleurs été déposée pour protéger une amélioration de cette technique sous le numéro EP 01810461.2.

A l'heure actuelle, les progrès de la miniaturisation passent par un empilement des puces. Cependant, les techniques mentionnées ci-dessus ne permettent pas de superposer plus de deux puces. De plus, la longueur des fils entre les puces et le substrat est importante et devient problématique dans le cas des applications à haute fréquence.

La présente invention a pour but de fournir un module électronique dont les moyens d'interconnexion sont de longueur réduite et permettant, par ailleurs, des empilements de plus de deux puces.

De façon plus précise, l'invention concerne un module électronique comportant :
- un support d'interconnexion comprenant un substrat souple, semi-rigide ou rigide doté d'une pluralité de zones de contact déposées sur sa face supérieure,
- une première puce électronique, fixée sur le substrat par sa face inactive et dotée, sur sa face active, d'une pluralité de plages de contact, et
- une deuxième puce électronique, dont la face active est dotée de protubérances conductrices, et montée sur la face active de la première puce de manière à mettre en contact lesdites protubérances et lesdites plages.

Selon un premier mode de réalisation préféré, les plages de contact de la première puce et les protubérances conductrices de la deuxième puce sont connectées directement.

Selon un deuxième mode de réalisation préféré, les plages de contact de la première puce et les protubérances conductrices de la deuxième puce sont reliées par une plaque intermédiaire dotée de plages d'adaptation la traversant. Cette technique est connue de l'homme de métier sous le nom de redistribution ou repadding.

Dans les deux cas, la face non active de la deuxième puce constitue avantageusement la face supérieure du module et peut être apprêtée pour supporter au moins une autre puce.

L'invention sera mieux comprise à la lumière de la description qui va suivre, faite en regard du dessin annexé, sur lequel :
- la figure 1 est une vue de dessus d'un module électronique à deux puces selon un premier mode de réalisation de l'invention, la puce supérieure étant montrée retournée et séparée de la puce inférieure;
- la figure 2 est une vue simplifiée, en perspective, du module de la figure 1, la puce supérieure étant montrée écorchée;
- la figure 3 est une vue simplifiée, en perspective d'un assemblage vertical d'une pluralité de puces ; et
- la figure 4 est une vue simplifiée, en perspective et écorchée, d'un module selon un deuxième mode de réalisation de l'invention.

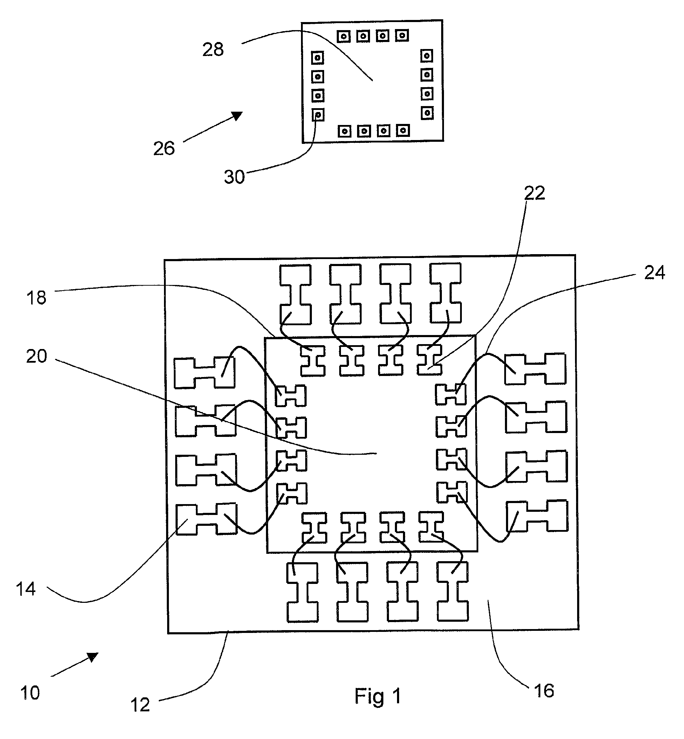

Sur la figure 1, on a représenté un module électronique 10 comportant un support d'interconnexion formé d'un substrat 12 souple, semi-rigide ou rigide, et une pluralité de zones de contact 14 en cuivre ayant, typiquement, une épaisseur de l'ordre de 10 à 30 µm, déposées sur la face supérieure 16 du substrat.

Un premier circuit intégré ou puce 18 est collé sur la face 16 par sa face inactive selon le mode "Chip on Board". Sa face active 20 possède une pluralité de plages de contact ou "pads" 22. Ces "pads" sont reliés un à un aux zones de contact 14 du substrat 12 par des fils conducteurs 24 selon le mode "wire bonding" bien connu de l'homme de métier.

Un deuxième circuit intégré ou puce 26 est représenté séparément sur la figure 1, en vue de dessus, du côté de sa face active 28. Celle-ci est dotée de protubérances conductrices ou "bumps" 30, en forme de champignon, avantageusement en or et également bien connues de l'homme de métier.

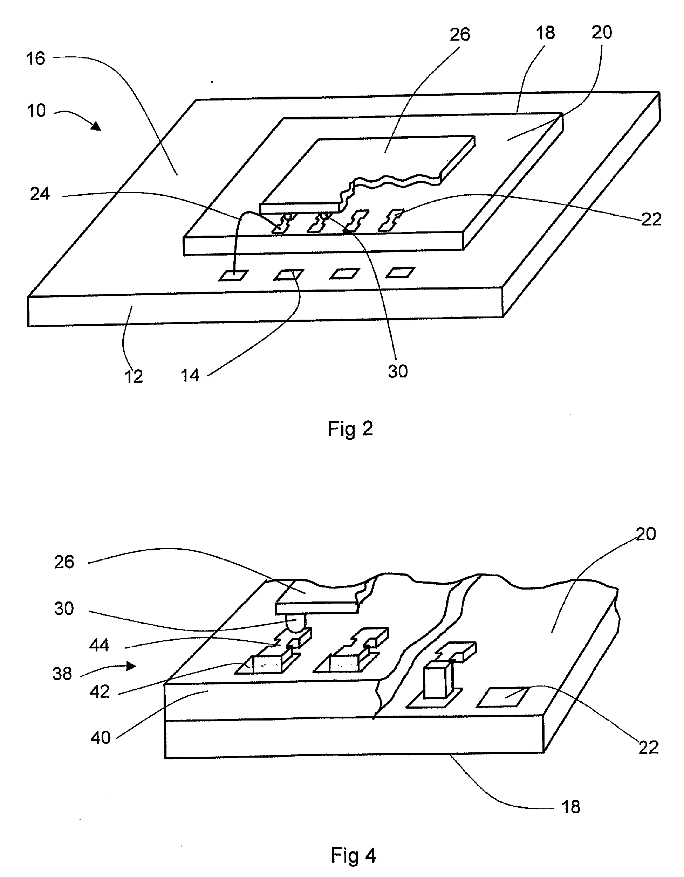

Les figures 1 et 2 montrent que la deuxième puce 26 est déposée en mode "Flip Chip" sur la première 18 de manière à ce que les "bumps" 30 de sa face active viennent au contact de "pads" 22. Le maintien des "pads" 22 sur les "bumps" 30 se fait directement et n'implique pas de soudage. Il est simplement assuré grâce à la présence d'une couche de colle, en principe non-conductrice, préalablement déposée sur la face active 20 de la puce 18 et qui remplit ensuite parfaitement l'espace entre les deux puces. La pression appliquée sur la puce 26 lors de sa mise en place est suffisante pour chasser la colle déposée entre les plages 22 et les protubérances 30, ce qui permet ainsi un contact optimal. Des précisions sur la mise en oeuvre du mode "Flip Chip" sont notamment données dans la demande de brevet EP précitée.

Ainsi, les signaux provenant de la puce inférieure 18 peuvent être traités par la puce supérieure 26, qui, à son tour, peut renvoyer des signaux vers la première, pour un nouveau traitement ou pour leur transmission au support d'interconnexion 10. Les organes de connexion entre les deux puces ayant une longueur très réduite, le module obtenu est, tout particulièrement, mais de façon non restrictive, adapté aux applications haute fréquence.

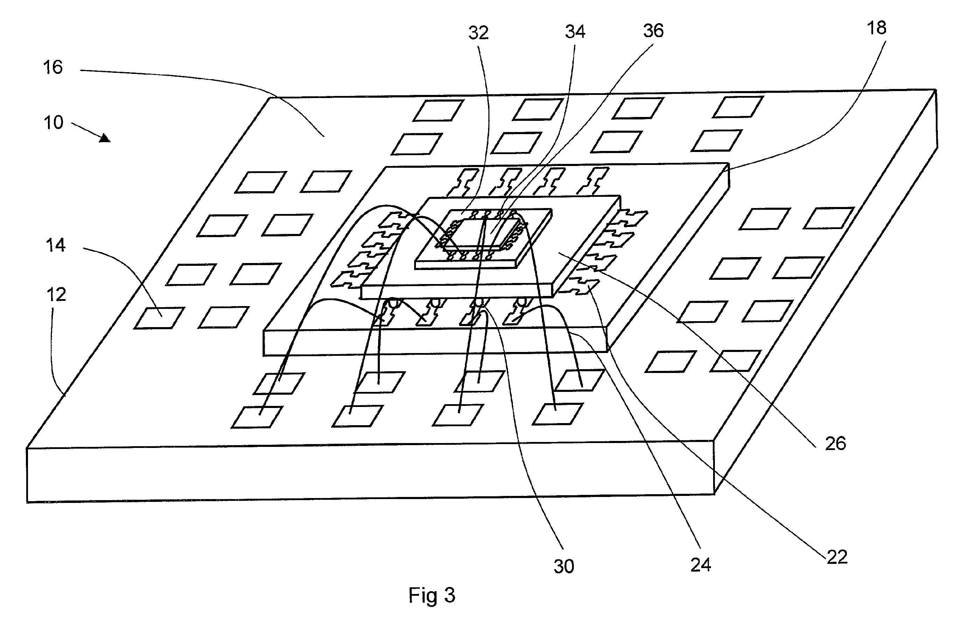

Ainsi qu'illustré par la figure 3, la face inactive du circuit 26, qui constitue la face supérieure du module, peut être le support d'une troisième puce 32 déposée selon le mode "Chip on Board". A son tour et comme mentionné précédemment, cette puce 32, comme la puce 18, est dotée, sur sa face active, d'une pluralité de "pads" 34 pour permettre le montage selon le mode "Flip Chip" d'une quatrième puce 36 munie de "bumps", non visibles sur la figure mais semblables à ceux de la puce 26. La description d'un tel assemblage n'est pas limitative et une pluralité de puces peut ainsi être superposée de la même manière.

Le mode de réalisation, qui vient d'être décrit en référence aux figures 1 à 3, implique que les "pads" 22 et les "bumps" 30, d'une part, et les "pads" 34 et les "bumps" de la puce 36, d'autre part, soient en regard l'un de l'autre, pour qu'ils puissent être superposés directement.

On se référera maintenant à la figure 4, qui représente un deuxième mode de réalisation préféré de l'invention, les éléments communs aux deux modes étant désignés par les mêmes numéros de référence. Dans ce cas, la puce supérieure 26 est identique à celle représentée sur la figure 1, alors que la puce inférieure 18 est standard, c'est à dire que ses "pads" 22 n'ont pas été placés spécialement pour se trouver directement en regard des "bumps" 30 de la puce supérieure 26. Un cadre intermédiaire 38 doit donc servir de relais. Il est constitué d'une plaque isolante 40, en benzo-cyclobutène par exemple, ayant une épaisseur de quelques microns, traversée par une série d'ouvertures 42 débouchant chacune sur un "pad" 22 de la puce inférieure 18.

La plaque 40 est dotée d'une pluralité de plages de contact ou "pads" d'adaptation 44, disposés dans les ouvertures 42, et conformés de manière à assurer la liaison entre les "pads" 22 de la puce inférieure 18 et les "bumps" 30 de la puce supérieure 26.

Dans cette variante également, la face inactive du circuit 26 constitue la face supérieure du module 10 et peut donc être le support d'une autre puce, non représentée sur la figure, déposée selon le mode dit "Chip on Board".

Il va de soi que la troisième puce, éventuellement collée sur la face inactive de la seconde, peut, à son tour et comme la puce 18, être apprêtée, comme la puce 18, selon l'un des deux modes de réalisation décrits ci-dessus afin de recevoir une quatrième puce, et ainsi de suite.

Bien entendu, l'invention ne se restreint pas aux détails de réalisation décrits ci-dessus. Ainsi, il est évident que tous les types de report et de connexions sont possibles à partir des différents étages du module.

## Revendications

1. Module électronique (10) **caractérisé en ce qu'**il comporte :
- un support d'interconnexion comprenant un substrat (12) souple, semi-rigide ou rigide et une pluralité de zones de contact (14) déposées sur sa face supérieure (16),
- une première puce électronique (18), fixée sur le substrat (12) par sa face inactive et dotée, sur sa face active (20), d'une pluralité de plages de contact (22), et
- une deuxième puce électronique (26), dont la face active (28) est dotée de protubérances conductrices (30), montée sur la face active (20) de la première puce de manière à mettre en contact lesdites protubérances (30) et lesdites plages (22).

2. Module selon la revendication 1, **caractérisé en ce que** les plages de contact (22) de la première puce (18) et les protubérances conductrices (30) de la deuxième (26) sont connectées directement.

3. Module selon la revendication 1, **caractérisé en ce que** les plages de contact (22) de la première puce (18) et les protubérances conductrices (30) de la deuxième (26) sont reliées par une plaque intermédiaire (40) dotée de plages d'adaptation (44) la traversant.

4. Module selon l'une des revendications 1 à 3, **caractérisé en ce que** la face non active de la deuxième puce (26) constitue sa face supérieure et peut être apprêtée pour supporter au moins une autre puce.
